# EUROPEAN PATENT APPLICATION

(11) **EP 4 814 965 A1**
(43) Date of publication of application: **30.09.2026**
(21) Application number: 26166543.4
(22) Date of filing: 20.03.2026
(51) Int. Cl.: G11C 11/16

(54) **MEMORY SYSTEM**

(30) Priority: 28.03.2025 JP 2025056929
(71) Applicant: AISIN CORPORATION, Kariya, Aichi 448-8650 (JP)
(72) Inventor: NARUSE, Takanobu, KARIYA, AICHI, 448-8650 (JP)
(74) Representative: Cabinet Beau de Loménie

(57) **Abstract**

A memory system according to an embodiment includes: an STT-MRAM having a plurality of memory areas for storing data; and a memory controller configured to control a write and a read for each of the plurality of memory areas, wherein upon receiving a write request of data (S1), the memory controller selects any of a plurality of writes having different write times on the basis of predetermined information related to the data (S2) and writes the data to a corresponding one of the memory areas (S3, S4, S5).

## Description

### TECHNICAL FIELD

An embodiment of the present disclosure relates to a memory system.

### BACKGROUND DISCUSSION

In recent years, spin transfer torque-magnetoresistive random access memory (STT-MRAM) has been researched and developed. The STT-MRAM is a memory (storage device) using a magnetoresistance effect, and has excellent features such as high-speed write (writing operation)/read (reading operation) and non-volatility as compared with conventional dynamic random access memory (DRAM), static random access memory (SRAM), and the like. As a next-generation memory, application in many fields such as smartphones, personal computers, and vehicles (such as automobiles) is promising.

The STT-MRAM typically has about one trillion rewrite cycles, and has a property that the longer the write time, the longer the data holding period (period in which data can be held). This is because the degree of alignment of a plurality of magnetic spins becomes stronger (that is, the stability of a magnetization state is enhanced) as the write time becomes longer.

In a case where data is written to the STT-MRAM, the length of storage time varies depending on the type and use of the data. Therefore, for example, a method is considered in which a high-speed access (write/read) STT-MRAM for short-time storage, a medium-speed access STT-MRAM for medium-time storage, and a low-speed access STT-MRAM for long-time storage are separately prepared and used (see JP 2016-115354 A).

However, the above-described method uses a plurality of STT-MRAMs, which leads to an increase in chip area and an increase in power consumption.

A need thus exists for a memory system that can execute a plurality of writes having different write times on one STT-MRAM.

### SUMMARY

A memory system according to an embodiment includes: an STT-MRAM having a plurality of memory areas for storing data; and a memory controller configured to control a write and a read for each of the plurality of memory areas, wherein upon receiving a write request of data, the memory controller selects any of a plurality of writes having different write times on the basis of predetermined information related to the data and writes the data to a corresponding one of the memory areas.

According to this configuration, the plurality of writes having different write times can be executed on one STT-MRAM.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a functional configuration diagram of an ECU according to an embodiment;
Fig. 2 is a conceptual diagram illustrating a write time and a memory transfer size to be used for each type of access to an MRAM;
Fig. 3 is a conceptual diagram illustrating sharing of the MRAM by high-speed access, medium-speed access, and low-speed access; and
Fig. 4 is a flowchart illustrating processing related to a write to the MRAM.

### DETAILED DESCRIPTION

Hereinafter, an exemplary embodiment of the present disclosure will be disclosed. A configuration of the embodiment described below, and actions, results, and effects brought by the configuration are examples. The present disclosure can be realized by a configuration other than that disclosed in the following embodiment, and at least one of various effects based on a basic configuration and derivative effects can be obtained. In the following embodiment, a case where a memory system of the present disclosure is applied to an electronic control unit (ECU) used in a vehicle (such as an automobile) or the like will be described as an example.

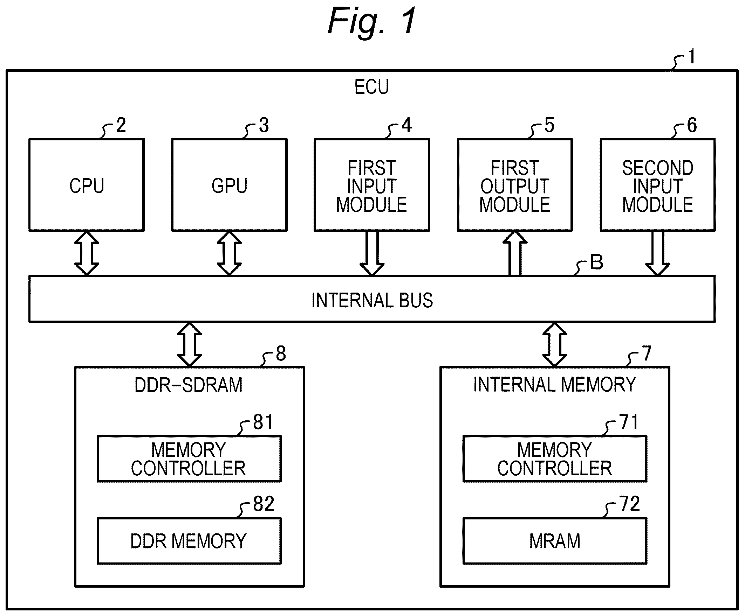

Fig. 1 is a functional configuration diagram of an ECU 1 according to an embodiment. In the ECU 1, a central processing unit (CPU) 2, a graphics processing unit (GPU) 3, a first input module 4, a first output module 5, a second input module 6, an internal memory 7 (memory system), and a double data rate-synchronous dynamic random access memory (DDR-SDRAM) 8 are disposed so as to be able to communicate with each other via an internal bus B. Note that this drawing is illustrated in a simplified manner, and in reality, for example, a direct memory access (DMA) controller, a cache memory, and the like may be provided as an additional configuration.

The CPU 2 executes various arithmetic processing. For example, the CPU 2 transmits an instruction signal to the first input module 4 or the second input module 6 to store input data in the internal memory 7 or the DDR-SDRAM 8.

The GPU 3 mainly executes image processing.

The first input module 4 transmits input predetermined data to the internal memory 7 or the DDR-SDRAM 8 via the internal bus B. The first input module 4 is, for example, a video input module.

The first output module 5 outputs predetermined data received from the internal memory 7 or the DDR-SDRAM 8 via the internal bus B. The first output module 5 is, for example, a display output module. In this case, for example, the GPU 3 transmits an instruction signal to the first output module 5 to cause a display device (not illustrated) to display the information received from the data internal memory 7 or the DDR-SDRAM 8.

Similarly to the first input module 4, the second input module 6 transmits input predetermined data to the internal memory 7 or the DDR-SDRAM 8 via the internal bus B.

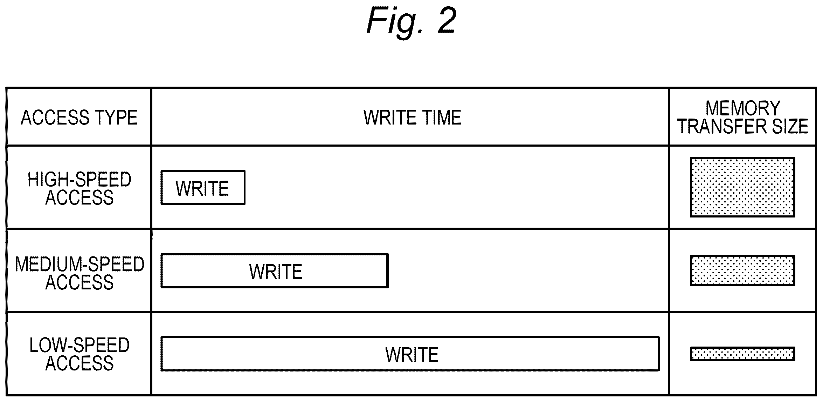

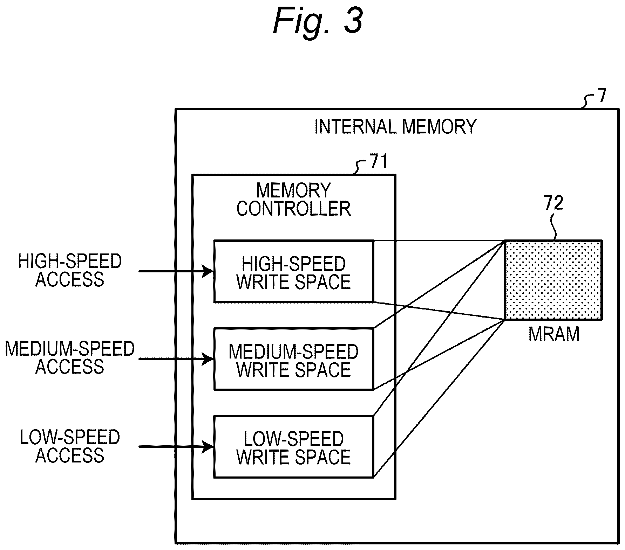

The internal memory 7 is a storage device, and includes a memory controller 71 and an MRAM 72 (STT-MRAM). Hereinafter, Figs. 2 and 3 will also be referred to. Fig. 2 is a conceptual diagram illustrating a write time and a memory transfer size (hereinafter, also referred to as "data transfer size") to be used for each type of access to the MRAM 72. Fig. 3 is a conceptual diagram illustrating sharing of the MRAM 72 by high-speed access, medium-speed access, and low-speed access.

The MRAM 72 has a plurality of memory areas for storing data.

The memory controller 71 controls a write, a read, a refresh (refreshing operation), and the like for each of the plurality of memory areas of the MRAM 72.

Upon receiving a write request of data, the memory controller 71 selects any of a plurality of writes having different write times on the basis of predetermined information related to the data, and writes the data to a corresponding memory area.

Here, as illustrated in Fig. 2, as three types of access to the MRAM 72, high-speed access (write) for short-time (for example, about several minutes) storage, medium-speed access for medium-time (for example, about several days) storage, and low-speed access for long-time (for example, about several years to several tens of years) storage are used.

The high-speed access is used, for example, in a case where the MRAM 72 is used as a frame buffer in image processing of a moving image. The write time is short. The data transfer size to be used is large.

The medium-speed access is used, for example, in a case where the MRAM 72 is used as a storage unit of setting data of a car navigation system. The write time is longer than that in the case of the high-speed access. The data transfer size to be used is smaller than that in the case of the high-speed access.

The low-speed access is used, for example, in a case where the MRAM 72 is used as a storage unit of an operating system (OS) or a boot program. The write time is longer than that in the case of the medium-speed access. The data transfer size to be used is smaller than that in the case of the medium-speed access.

As illustrated in Fig. 3, in the case of the high-speed access, the memory controller 71 performs the high-speed access by referring to a high-speed write space in which management information (such as a memory area address to be used) for the use of the high-speed access is stored.

In the case of the medium-speed access, the memory controller 71 performs the medium-speed access by referring to a medium-speed write space in which management information for the use of the medium-speed access is stored.

In the case of the low-speed access, the memory controller 71 performs the low-speed access by referring to a low-speed write space in which management information for the use of the low-speed access is stored.

Returning to Fig. 1, upon receiving a write request of data, the memory controller 71 selects any of the plurality of writes having different write times on the basis of transmission source address information as the predetermined information related to the data, and writes the data to a corresponding memory area. For example, in a case where the transmission source address information is an address of the video input module as the first input module 4, the memory controller 71 performs a high-speed write. However, in a case where it becomes necessary to store a video for a long period of time (for example, when a drive recorder of a vehicle stores a video at the occurrence of a vehicle accident), the memory controller 71 may be switched to perform a low-speed write.

Upon receiving a write request of data, the memory controller 71 selects any of the plurality of writes having different write times on the basis of transmission source module information as the predetermined information related to the data, and writes the data to a corresponding memory area. For example, in a case where the transmission source module information is an identifier (ID) of the video input module as the first input module 4, the memory controller 71 performs a high-speed write.

Upon receiving a write request of data, the memory controller 71 selects any of the plurality of writes having different write times on the basis of data transfer size information as the predetermined information related to the data, and writes the data to a corresponding memory area. For example, in a case where the data transfer size information indicates large data (that data is large), the memory controller 71 performs a high-speed write. In a case where the data transfer size information indicates medium data (that data is medium), the memory controller 71 performs a medium-speed write. In a case where the data transfer size information indicates small data (that data is small), the memory controller 71 performs a low-speed write.

In the case of selecting any of the plurality of writes having different write times, the memory controller 71 may select the write by using two or more of a plurality of pieces of information including the transmission source address information, the transmission source module information, and the data transfer size information.

The DDR-SDRAM 8 includes a memory controller 81 and a DDR memory 82. In the present embodiment, the DDR-SDRAM 8 refers to the following.
(1) Low-power (LP) DDR4-SDRAM, LPDDR4x-SDRAM, LPDDR5-SDRAM, LPDDR5x-SDRAM, or the like (for example, applied to a smartphone or a vehicle)
(2) Graphics (G) DDR5-SDRAM, GDDR5x-SDRAM, GDDR6-SDRAM, GDDR7-SDRAM, or the like (for example, applied to a graphic board)
(3) DDR4-SDRAM, DDR5-SDRAM, DDR6-SDRAM, or the like (for example, applied to a personal computer)

The DDR memory 82 has a plurality of memory areas for storing data.

The memory controller 81 controls a write, a read, a refresh, and the like for each of the plurality of memory areas of the DDR memory 82.

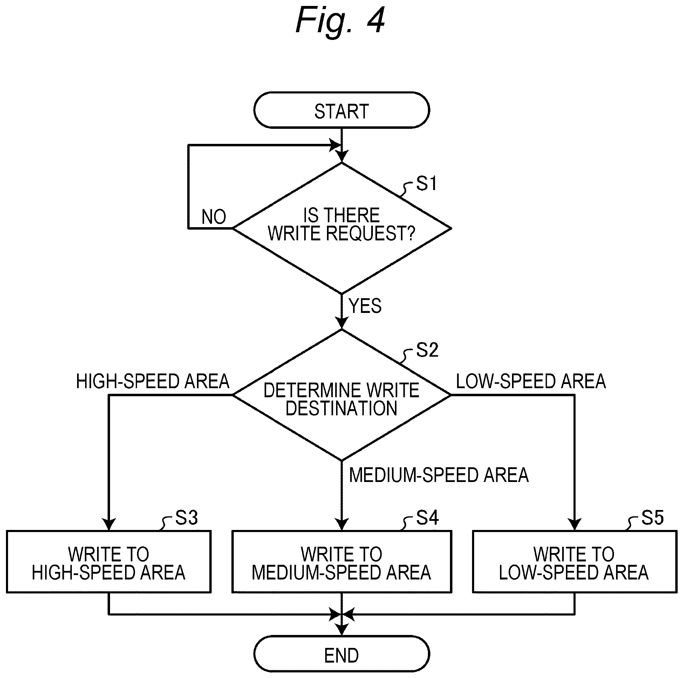

Fig. 4 is a flowchart illustrating processing related to a write to the MRAM 72. In step S1, the memory controller 71 determines whether there is a write request from the first input module 4 or the like. In the case of Yes, the process proceeds to step S2, and in the case of No, the process returns to step S1.

In step S2, the memory controller 71 determines whether a write destination is a high-speed area (memory area for the high-speed access in the MRAM 72), a medium-speed area (memory area for the medium-speed access in the MRAM 72), or a low-speed area (memory area for the low-speed access in the MRAM 72) by using one or more of the plurality of pieces of information including the transmission source address information, the transmission source module information, and the data transfer size information related to the data for which the write request has been made.

In a case where the write destination is the high-speed area, in step S3, the memory controller 71 writes the data to the high-speed area in the MRAM 72.

In a case where the write destination is the medium-speed area, in step S4, the memory controller 71 writes the data to the medium-speed area in the MRAM 72.

In a case where the write destination is the low-speed area, in step S5, the memory controller 71 writes the data to the low-speed area in the MRAM 72.

As described above, according to the internal memory 7 of the present embodiment, when a write request of data is received, any of the plurality of writes having different write times is selected on the basis of the predetermined information related to the data, and the data is written to a corresponding memory area. This makes it possible to selectively execute the plurality of writes having different write times on one MRAM 72. Therefore, an increase in chip area and an increase in power consumption can be suppressed.

The transmission source address information can be used as the predetermined information related to the data. This makes it possible to determine the type of the write according to the transmission source address.

The transmission source module information can also be used as the predetermined information related to the data. This makes it possible to determine the type of the write according to the transmission source module.

The data transfer size information can also be used as the predetermined information related to the data. This makes it possible to determine the type of the write according to the data transfer size.

Note that the program executed by the ECU 1 may be provided as a computer program product by being stored as a file in an installable format or an executable format in a computer-readable storage medium such as a CD-ROM, a CD-R, a memory card, a digital versatile disk (DVD), or a flexible disk (FD). Moreover, the program may be provided by being stored on a computer connected to a network such as the Internet and downloaded via the network. Furthermore, the program may be provided or distributed via a network such as the Internet.

Although the embodiment of the present disclosure has been described above, the above embodiment has been presented as an example, and is not intended to limit the scope of the disclosure. This novel embodiment can be implemented in various other forms, and various omissions, substitutions, and changes can be made without departing from the gist of the disclosure. This embodiment and modifications thereof are included in the scope and gist of the disclosure and are included in the disclosure described in the claims and the scope of equivalents thereof.

For example, an application destination of the memory system of the present disclosure is not limited to the ECU used in a vehicle or the like of the above-described embodiment, and may be another field such as a smartphone or a personal computer.

Furthermore, in the above-described embodiment, the three types of writes have been described as an example of the plurality of writes having different write times, but the plurality of writes is not limited thereto, and two types of writes or four or more types of writes may be used.

### Summary of Present Embodiment

The present embodiment includes at least the following configuration.

A memory system according to an embodiment includes: an STT-MRAM having a plurality of memory areas for storing data; and a memory controller configured to control a write and a read for each of the plurality of memory areas, wherein upon receiving a write request of data, the memory controller selects any of a plurality of writes having different write times on the basis of predetermined information related to the data and writes the data to a corresponding one of the memory areas.

With such a configuration, the plurality of writes having different write times can be executed on one STT-MRAM.

Upon receiving a write request of data, the memory controller selects any of the plurality of writes having different write times on the basis of transmission source address information as the predetermined information related to the data, and writes the data to a corresponding one of the memory areas.

With such a configuration, the type of the write can be determined according to a transmission source address.

Upon receiving a write request of data, the memory controller selects any of the plurality of writes having different write times on the basis of transmission source module information as the predetermined information related to the data, and writes the data to a corresponding one of the memory areas.

With such a configuration, the type of the write can be determined according to a transmission source module.

Upon receiving a write request of data, the memory controller selects any of the plurality of writes having different write times on the basis of data transfer size information as the predetermined information related to the data, and writes the data to a corresponding one of the memory areas.

With such a configuration, the type of the write can be determined according to a data transfer size.

Note that the effects of the dependent claims and the embodiment are additional effects different from the effects of the independent claim.

## Claims

1. A memory system (7) comprising:
a spin transfer torque-magnetoresistive random access memory (STT-MRAM) (72) having a plurality of memory areas for storing data; and
a memory controller (71) configured to control a write and a read for each of the plurality of memory areas, wherein
the memory controller (71) is configured to, upon receiving a write request of data, select any of a plurality of writes having different write times on a basis of predetermined information related to the data, and write the data to a corresponding one of the memory areas.

2. The memory system (7) according to Claim 1, wherein
the memory controller (71) is configured to, upon receiving a write request of data, select any of the plurality of writes having different write times on a basis of transmission source address information as the predetermined information related to the data, and write the data to a corresponding one of the memory areas.

3. The memory system (7) according to Claim 1, wherein
the memory controller (71) is configured to, upon receiving a write request of data, select any of the plurality of writes having different write times on a basis of transmission source module information as the predetermined information related to the data, and write the data to a corresponding one of the memory areas.

4. The memory system (7) according to Claim 1, wherein
the memory controller (71) is configured to, upon receiving a write request of data, select any of the plurality of writes having different write times on a basis of data transfer size information as the predetermined information related to the data, and write the data to a corresponding one of the memory areas.
